(19) Europäisches Patentamt

European Patent Office

Office européen des brevets

(11) Veröffentlichungsnummer: **0 293 575 B1**

# (12) EUROPÄISCHE PATENTSCHRIFT

(45) Veröffentlichungstag der Patentschrift: **22.06.94**

(21) Anmeldenummer: **88105515.6**

(22) Anmeldetag: **07.04.88**

(51) Int. Cl.⁵: **H01L 27/02**

(54) **Integrierte Schaltungsanordnung mit Schutzanordnung.**

(30) Priorität: **02.05.87 DE 3714647**

(43) Veröffentlichungstag der Anmeldung:
**07.12.88 Patentblatt 88/49**

(45) Bekanntmachung des Hinweises auf die
Patenterteilung:
**22.06.94 Patentblatt 94/25**

(84) Benannte Vertragsstaaten:
**DE FR GB IT NL**

(56) Entgegenhaltungen:
**EP-A- 0 043 284**
**WO-A-86/06213**
**DE-B- 2 951 931**

(73) Patentinhaber: **TEMIC TELEFUNKEN microelectronic GmbH
Theresienstrasse 2
D-74072 Heilbronn(DE)**

(72) Erfinder: **Rinderle, Heinz
Goerdelerstrasse 82
D-7100 Heilbronn(DE)**

(74) Vertreter: **Maute, Hans-Jürgen, Dipl.-Ing.
TEMIC TELEFUNKEN microelectronic GmbH
Postfach 35 35
D-74025 Heilbronn (DE)**

**Beschreibung**

Die Erfindung betrifft eine Schaltungsanordnung mit einer zumindest teilweise mitintegrierten Schutzanordnung, die die integrierte Schaltungsanordnung vor energiereichen elektrischen Störungen schützt, die auf sie einwirken.

Energiereiche elektrische Störungen sind z.B. Störungen, die durch elektrostatische Entladungen entstehen und die bei der Handhabung von integrierten Schaltungen auf deren Anschlüsse einwirken können und dabei nichtreversible Veränderungen in der integrierten Schaltung bis zu deren Zerstörung verursachen können. Solche elektrostatischen Entladungen treten in vielfältigen Arten und Stärken auf und sind deshalb im einzelnen schwer zu beschreiben. Um jedoch die Empfindlichkeit von integrierten Schaltungen gegenüber solchen Störungen mit einer endlichen Wahrscheinlichkeit erfassen zu können, werden zunehmend - wie bei elektronischen Bauelementen generell - auch integrierte Schaltungen Streßtests unterzogen, bei denen die elektrostatischen Entladungsvorgänge mittels bestimmter Testanordnungen nachgebildet werden. Bei diesen Tests werden nach einem vorgeschriebenen Schema die Anschlüsse der integrierten Schaltung einer bestimmten Impulsbelastung unterzogen.

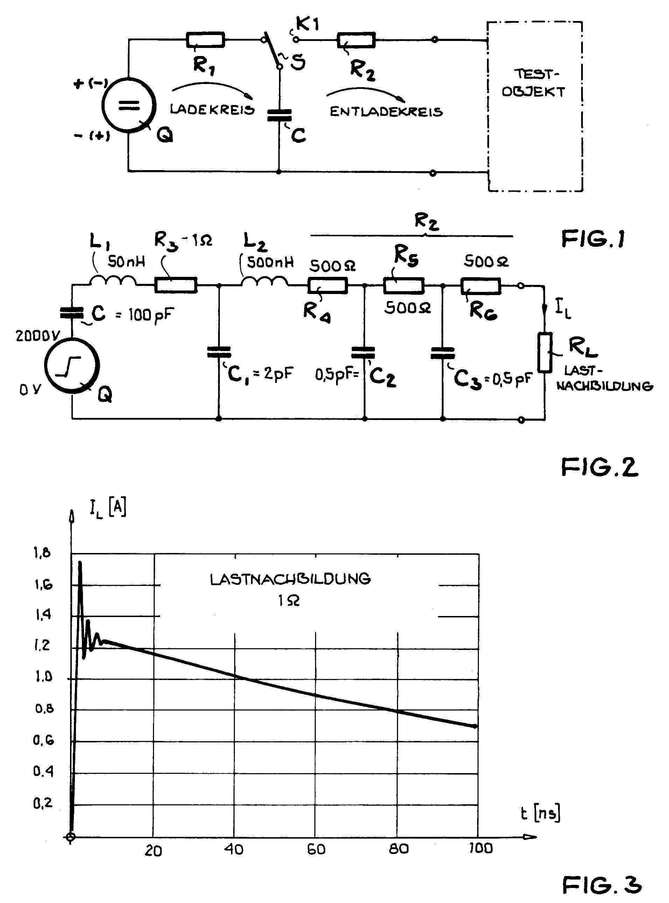

Im Prinzip wird bei Streßtests ein Kondensator vorgegebener Kapazität auf eine vorgegebene Spannung aufgeladen und unter bestimmten Bedingungen über das zu testende Bauelement entladen. In der Praxis werden zwei Versionen von Testschaltungen bevorzugt, die im folgenden näher beschrieben werden. Die erste Version einer Testschaltung zeigt die Figur 1. Bei der Testschaltung der Figur 1 wird der Kondensator C von einer Spannungsquelle Q über den Widerstand R1 geladen und durch Umschalten des Schalters S über den Widerstand R2 und das Testobjekt entladen. Der Widerstand R2 dient hierbei nur zum Schutz der Quelle Q und zur Vermeidung gefährlicher Körperströme im Berührungsfalle.

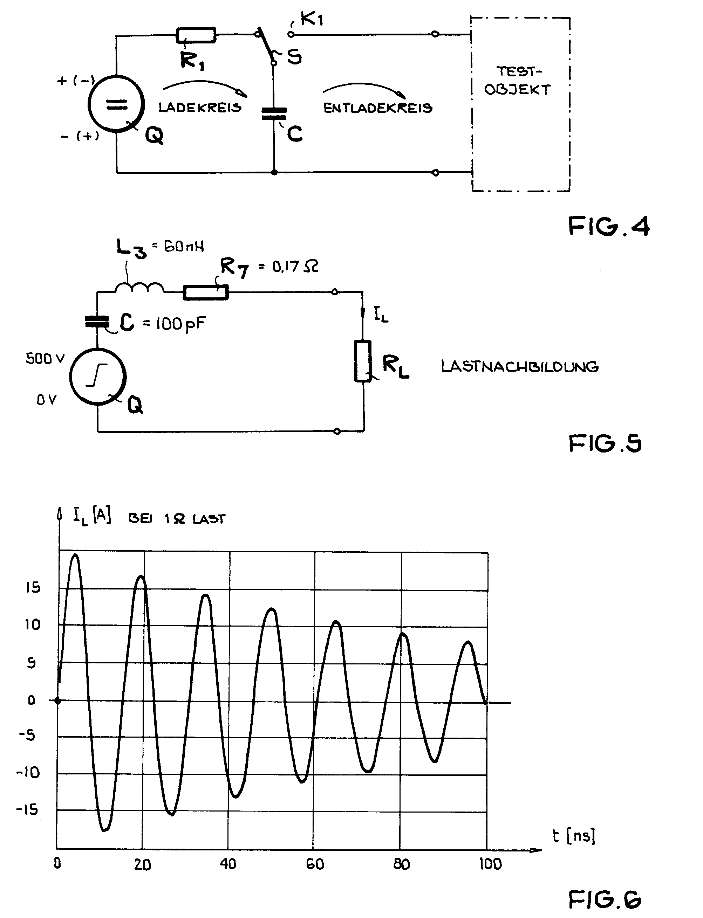

Die zweite Version einer Testschaltung zeigt die Figur 4. Die Testschaltung der Figur 4 unterscheidet sich von der Testschaltung der Figur 1 dadurch, daß bei ihr der Widerstand R2 der ersten Version entfällt. Durch den Wegfall des Widerstandes R2 bei der zweiten Version wirkt bei der Testschaltung der zweiten Version (Figur 4) die volle elektrische Energie des geladenen Kondensators C auf das Testobjekt ein. Die erste Version der Testschaltung wird vornehmlich für den Test von MOS-Schaltungen eingesetzt, während in zunehmenden Maße die zweite Version zum Testen von bipolaren integrierten Schaltungen eingesetzt wird. Die entsprechenden Testvorschriften besagen, daß die Tests mit beiden Polaritäten durchzuführen sind.

Die an integrierten Schaltungen durchgeführten Streßtests haben gezeigt, daß das Erscheinungsbild der geschädigten Bauelemente dem in der Praxis auftretenden Erscheinungsbild weitgehend entspricht, so daß die beschriebenen Testmethoden mehr und mehr mit zur Beurteilung von integrierten Schaltungen herangezogen werden. Auch werden zur Entwicklung von Schutzanordnungen für integrierte Schaltungen solche Testverfahren zur Bewertung der Schutzanordnung verwendet.

Um einen Überlick über die Vorgänge zu erhalten, die sich bei den Testversuchen mittels der bekannten Testschaltungen (Version 1 oder Version 2) abspielen, wurden die ablaufenden Entladungsvorgänge durch Simulation erfaßt, da diese wegen des nichtperiodischen und schnellen Ablaufs der Vorgänge meßtechnisch praktisch nicht zu erfassen sind. Hierzu mußte zunächst die Testschaltung in eine für die Simulation geeignete Ersatzschaltung umgewandelt werden. Die Figur 2 zeigt die zur Simulation eingesetzte Ersatzschaltung der Testschaltung nach Figur 1 (Version 1). Bei der Simulation wurde das Testobjekt zunächst durch einen ohmschen Lastwiderstand $R_L$ ersetzt. Der Lastwiderstand $R_L$ wurde zunächst mit 1 Ohm angesetzt. In der Ersatzschaltung nach Figur 2 wird der Umschaltvorgang des Schalters S durch einen Spannungssprung des Generators Q simuliert. Die maßgebenden Schaltelemente des Entladungskreises sind nach Figur 2 durch die Schaltelemente C, L1, R3, C1, L2, R4, C2, R5, C3, R6 und $R_L$ dargestellt.

Die Induktivität L1 der Ersatzschaltung nach Figur 2 charakterisiert die Anschlußinduktivität des Kondensators C. Der Widerstand R3 charakterisiert die Übergangswiderstände des Schalters S und der Kondensator C1 stellt die Kapazität des Schalters S in der Schalterstellung K1 sowie die Zuleitungskapazitäten zum Widerstand R2 dar. Der Widerstand R2 wird durch die Schaltelemente L2, R4, R5, C3 und R6 nachgebildet. Die Lastnachbildung erfolgt durch den Widerstand $R_L$.

Die Figur 3 zeigt das Ergebnis der Simulation bei Zugrundelegung der Ersatzschaltung nach Figur 2. Bei der Simulation wurde der Spannungsgenerator Q von Null auf 2000 V (plus) geschaltet. Die Figur 3 zeigt den Stromverlauf in Abhängigkeit von der Zeit bei Verwendung eines ohmschen Widerstandes $R_L$ = 1 Ohm als Lastnachbildung. Der in der Figur 3 dargestellte Strom ist der Strom, der durch den Lastwiderstand fließt.

Die Figur 5 zeigt die Ersatzschaltung für die Testschaltung nach der Figur 4. Die Induktivität L3 charakterisiert die Eigeninduktivität des Entladekreises, während der Widerstand R7 die Eigendämpfung des Entladekreises charakterisiert. Die Lastnachbildung erfolgt durch $R_L$.

Die Figur 6 zeigt das Ergebnis der Simulation mit Hilfe der Ersatzschaltung nach Figur 5 , und zwar für einen Spannungssprung des Generators Q im Zeitpunkt Null von Null auf 500 V. $R_L$ hat dabei ebenfalls einen Wert von 1 Ohm. Wie in der Figur 3 erstreckt sich der simulierte Zeitbereich (Abszisse) von 0 bis 100 nsec.

Vergleicht man die Figuren 3 und 6 miteinander, so sieht man, daß bei Anwendung der zweiten Testschaltung (Figur 4) wesentlich höhere Ströme auftreten als bei Anwendung der ersten Testschaltung (Figur 1). Dieses Ergebnis gilt für beide Polaritäten der Generatorspannung. Dabei ist noch zu berücksichtigen, daß die Spannung des Generators Q, die bei der zweiten Testmethode angewendet wurde, wesentlich niedriger ist als die Spannung, die bei der ersten Testmethode angewendet wurde, nämlich 500 V im Vergleich zu 2000 V bei der ersten Testmethode.

Aus diesem Vergleich ergibt sich, daß die zweite Testmethode für den zu testenden integrierten Schaltkreis wesentlich kritischer ist (erscheint) als die erste Testmethode.

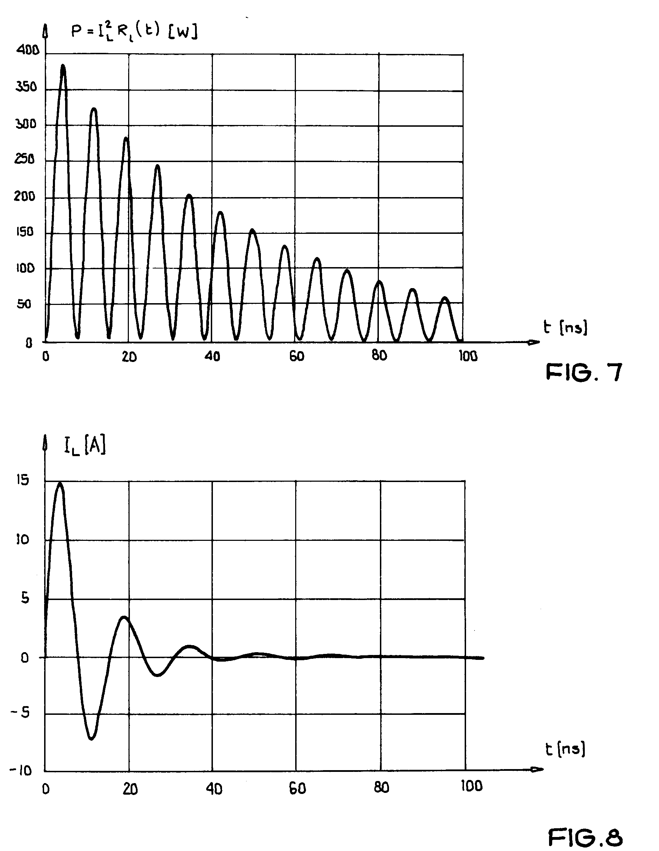

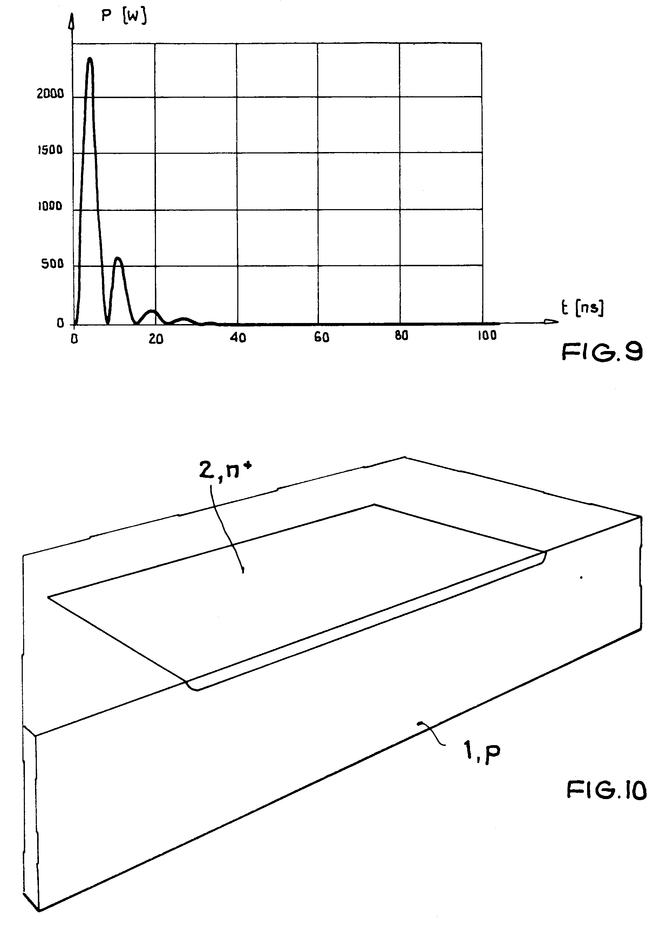

Neben dem Strom-Zeitverlauf interessiert auch der Leistungs-Zeitverlauf. Die Figur 7 zeigt den Leistungs-Zeitverlauf am Lastwiderstand $R_L$, wenn $R_L$ = 1 Ohm ist. Der Leistungs-Zeitverlauf der Figur 7 ist ebenfalls durch Simulation gewonnen worden, und zwar durch Produktbildung von Spannung und Strom am Widerstand $R_L$. Der Strom-Zeitverlauf wurde mittels der Ersatzschaltung nach Figur 4 ermittelt. Dies gilt auch für die Figuren 8 und 9, von denen die Figur 8 den Strom-Zeitverlauf für einen Lastwiderstand $R_L$ = 11 Ohm und Figur 9 den Leistungs-Zeitverlauf ebenfalls für einen Lastwiderstand $R_L$ = 11 Ohm zeigt. Danach bedingt ein höherer Wert für $R_L$ das Auftreten einer wesentlich höheren Spitzenleistung bei gleichzeitig schnellerem Abklingen. Die Darstellungen zeigen, daß die Kurzzeitbelastung wesentlich höher ist, je höher der Lastwiderstand in dem dargestellten Wertebereich ist.

Untersuchungen haben gezeigt, daß integrierte Schaltungen, die den beschriebenen Tests unterzogen werden, häufig im Bereich der belasteten Schaltungsteile lokale "Schmelzkanäle" aufweisen, die auf starke lokale Erhitzung zurückzuführen sind. Solche Erscheinungen finden sich vorwiegend in den Halbleiterzonen mit niedriger Dotierung. Es ist daher wahrscheinlich, daß die "Schmelzkanäle" durch temperaturinjizierte Eigenleitung des Halbleitermaterials entstehen, die ab bestimmten Temperaturen die Störstellenleitung übersteigt. Da die Eigenleitung (Intrinsicdichte) exponentiell mit der Temperatur ansteigt, konzentriert sich in einem solchen "angefachten" Halbleiterbereich der Strom lawinenartig und erhitzt so lokal das Halbleitermaterial. Dieser Vorgang ist im allgemeinen nicht kontrollierbar. Dies wird verständlich, wenn, wie die Theorie über die Temperaturabhängigkeit der Eigenleitfähigkeit (Intrinsicdichte) für Silizium aussagt, in einer Siliziumzone mit einer Störstellenkonzentration von z.B. $10^{15}$ cm$^{-3}$ bereits bei einer Temperatur von ca. 280 °C die Eigenleitung für den elektrischen Widerstand bestimmend ist, d.h. ab einer solchen Kristalltemperatur die Leitfähigkeit exponentiell ansteigt. Vergleichsweise ist bei einer Störstellenkonzentration von $10^{19}$ cm$^{-3}$ dies erst ab ca. 1400 °C der Fall, also bei Temperaturen nahe dem Schmelzpunkt des Siliziums.

Die DE-A-29 51 931 beschreibt eine Schutzanordnung mit einem Widerstandsbereich, der als vergrabene Schicht auf einem Halbleiterstubstrat angeordnet ist. Der Widerstandsbereich bildet mit dem Substrat eine erste Diode. Auf dem Widerstandsbereich befinden sich epitaktische Schichten, die eine zweite Diodenstruktur bilden. Die zweite Diode wird ebenso wie die erste Diode mit dem Massepotential verbunden. Der Anschluß der zu schützenden Schaltung erfolgt über den Widerstandsbereich. An den beiden gegenüberliegenden Seiten des Widerstandsbereichs sind dazu Kontakte vorgesehen. Die Dioden liegen parallel zwischen dem Schaltungseingang und dem Massepotential.

Die WO-A-86 06 213 beschreibt eine Schutzanordnung, wobei der Widerstandsbereich aus einem Diffusionsgebiet besteht.

Die EP-A-43 284 zeigt eine Schutzanordnung, die aus einem Widerstandsbereich besteht, über den der Anschluß der Schaltungsanordnung erfolgt. Der Widerstandsbereich bildet mit dem Substrat Dioden, über die Störungen abgeleitet werden.

Der Erfindung liegt die Aufgabe zugrunde, eine Schutzanordnung für eine integrierte Schaltungsanordnung anzugeben, die eine verbesserte Schutzwirkung aufweist und die Störungen auf eine möglichst große Fläche ableitet.

Diese Aufgabe wird durch eine Anordnung mit den kennzeichnenden Merkmalen der Ansprüche 1 oder 2 gelöst. Die vorteilhafte Ausgestaltung der Erfindung erfolgt gemäß den Merkmalen der abhängigen Ansprüche.

Die Schutzanordnung weist einen ohmschen Widerstand in Gestalt von einem oder mehreren Widerstandsbereichen auf, der derart ausgebildet ist, daß er bei Grenzbelastung den wesentlichen Teil der Energie der elektrischen Störung aufnimmt und daß er die Wärme, die durch die Energieaufnahme in ihm erzeugt wird, auf eine solche Fläche der Schutzschaltung verteilt, daß die von der Wärmeenergie des ohmschen Widerstandes erfaßte Fläche der Schutzanordnung thermisch nicht überbelastet wird, und daß die Schutzanordnung zur Begrenzung der Störspannung ein spannungsbegrenzendes Element oder mehrere spannungsbegrenzende Elemente aufweist.

Das spannungsbegrenzende Element bzw. die spannungsbegrenzenden Elemente ist (sind) vorzugsweise so ausgebildet, daß die ihm (ihnen) zugeführte Entladungsenergie das spannungsbegrenzende Element bzw. die spannungsbegrenzenden Elemente nicht überlastet.

Die ohmschen Widerstandsbereiche sind als Widerstandszonen im Halbleiterkörper der integrierten Schaltungsanordnung ausgebildet. Es ist vorteilhaft, die Widerstandszonen aus Halbleiterzonen zu bilden, die eine höhere Störstellenkonzentration (z.B. größer $10^{19}$ cm$^{-3}$) aufweisen. Dadurch wird der Einfluß der unkontrollierbaren Eigenleitung, die zu einer instabilen Stromverteilung im Halbleiter führen kann, vermieden. Ein Widerstand im Halbleiterbereich ist im Abstand von der Halbleiteroberfläche entsprechend einer buried layer angeordnet.

Eine weitere Möglichkeit, einen isolierten Widerstand mit hochdotierter Halbleiterschicht zu bilden, besteht beispielsweise durch die Verwendung einer p$^+$-Diffusion, die durch eine n-Epitaxialschicht in eine buried layer-Zone eingebracht wird.

Ein anderer Aspekt für die erfindungsgemäße Ausbildung der Widerstandszone ist das Vermeiden eines Feldstärkedurchbruchs in der Widerstandszone. Durch einen Feldstärkedurchbruch kann nämlich die Widerstandszone unwirksam oder teilweise unwirksam werden. Dies kann z.B. dadurch entstehen, daß die Durchbruchstrecke die Widerstandszone ganz oder teilweise überbrückt. Die Widerstandszone ist daher so anzulegen, daß bei der maximal auftretenden Streßbelastung an keiner Stelle der Widerstandszone die Durchbruchfeldstärke (2...10 x $10^5$ V/cm) auftreten kann.

Gemäß einer Weiterbildung der Erfindung ist vorgesehen, daß die Entladungsenergie teilweise im Substrat des Halbleiterkörpers (Substrat für Schutzanordnung und integrierte Schaltungsanordnung) in Wärmeenergie umgesetzt wird, indem der Entladungsvorgang über den als Widerstand dienenden Substratbereich geleitet wird. Dies hat den Vorteil, daß die übrigen Teile der Schutzanordnung hinsichtlich des Kristallflächenbedarfs kleiner bemessen werden können, da deren elektrische Belastung geringer ist. Ein weiterer Vorteil der Nutzung des Substratwiderstandes besteht darin, daß der Spannungsabfall im Substratbereich nicht als Spannungsbelastung für die Zone zwischen dem Anschluß-Pad und dem darunter liegenden Substratbereich wirksam ist, wenn dieser Substratbereich mit dem Substratbereich der Schutzanordnung verbunden ist. Im Falle der Nutzung des Substratwiderstandes ist jedoch zu beachten, daß, durch den Spannungsabfall im maßgebenden Substratwiderstand bedingt, das Ausgangspotential der Schutzanordnung bei Auftreten der Störung um die am Substratwiderstand abfallende Spannung, je nach Polarität der Störung, vermindert oder angehoben wird.

Um negative Einflüsse dieses Spannungsabfalls auf die zu schützende Schaltung zu vermeiden, empfiehlt es sich, den massebezogenen Bezugspunkt der zu schützenden Schaltung unmittelbar dem Substratbereich zuzuordnen, mit dem das spannungsbegrenzende Element der Schutzanordnung verbunden ist. Damit wird sichergestellt, daß der zu schützenden Schaltung im Störfalle nur Spitzenspannungen zugeführt werden, die der Größe der an den spannungsbegrenzenden Elementen der Schutzanordnung auftretenden Spannungen entsprechen.

Ferner ist es vorteilhaft, den Substratbereich der Schutzanordnung von den übrigen Substratbereichen der integrierten Schaltung zu "entkoppeln" und den Substratbereich der Schutzanordnung mit dem Bezugspunkt (Masse) der integrierten Schaltung über eine separate Leitbahn zu verbinden, wobei der gewünschte (erforderliche) Substratwiderstand der Schutzanordnung durch entsprechende Ausbildung der Separationsanschlußzone realisiert werden kann. Eine "Entkopplung" des Substratbereiches der Schutzanordnung von den Substratbereichen der übrigen integrierten Schaltung hat den Vorteil, daß dadurch im Störungsfall, über den unmittelbar geschützten Schaltungsteil hinausgehend, eine größere Schutzwirkung für andere integrierte Schaltungsteile erreicht wird.

Eine "Entkopplung" des Substratbereichs der Schutzanordnung von den Substratbereichen der anderen Schaltungsteile kann beispielsweise dadurch realisiert werden, daß um den Substratbereich des zugeordneten AnschlußPads der integrierten Schaltung, eine Zone mit verhältnismäßig geringer Leitfähigkeit vorgesehen ist, die den niederohmigen Substratbereich der Schutzanordnung einschließt und von den anderen niederohmigen Substrathereichen der integrierten Schaltung trennt. Die niederohmigen Substratbereiche werden im allgemeinen durch eine Separationsdiffusion vom p-Leitungstyp gebildet, während die Zone mit der verhältnismäßig niederen Leitfähigkeit durch den niederdotierten Bereich vom p-Leitungstyp des Substratmaterials des Halbleiterkörpers bestimmt wird.

Die Erfindung wird im folgenden an Ausführungsbeispielen erläutert.

Die Figuren 10 bis 14 zeigen die Herstellung einer Schutzanordnung nach der Erfindung, die eine integrierte Schaltungsanordnung schützen soll, die sich im selben Halbleiterkörper wie die Schutzanordnung befindet, jedoch in den folgenden Figuren nicht dargestellt ist. Gemäß der Figur 10 geht man bei der Herstellung der Schutzanordnung von einem Halbleiterkörper 1 (auch Halbleiterkörper der nicht dargestellten integrierten Schaltungsanordnung) aus, der im Ausführungsbeispiel den p-Leitungstyp aufweist. In den Halbleiterkörper 1 wird gemäß der Figur 10 ein Widerstandsbereich 2 eingebracht, dessen Leitungstyp dem des Halbleiterkörpers 1 entgegengesetzt ist und der somit in der Figur 10 den n-Leitungstyp aufweist. Der Widerstandsbereich 2 ist relativ stark dotiert und weist beispielsweise eine Störstellenkonzentration von $10^{19}$ cm$^{-3}$ auf.

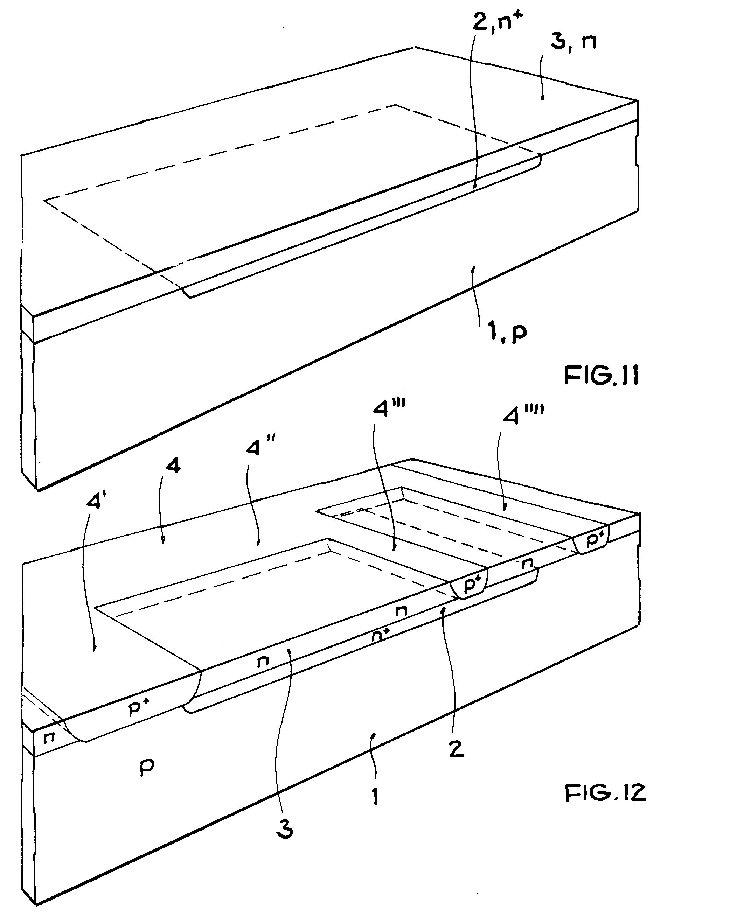

Nach der Figur 11 wird auf den Halbleiterkörper 1 (Substrat) vom p-Leitungstyp mit dem Widerstandsbereich 2 vom n-Leitungstyp eine epitaktische Schicht 3 vom n-Leitungstyp aufgebracht, so daß der Widerstandsbereich 2 zwischen dem Substrat 1 und der epitaktischen Schicht 3 begraben ist (buried layer). Nach der Figur 12 wird in die epitaktische Schicht 3 eine Halbleiterzone 4 vom p-Leitungstyp eingebracht, deren Bereiche 4', 4'' und 4''' mit dem angrenzenden Widerstandsbereich 2 eine Zenerdiode bilden, die als spannungsbegrenzendes Element dient. Die p-Bereiche 4' und 4'' erfüllen zusätzlich noch zusammen mit dem p-Bereich 4'''' die Funktion einer Separationszone. Der p-Bereich 4''' berührt den Widerstandsbereich 2 auf der gesamten Unterseite, während der p-Bereich 4' den Widerstandsbereich nur am Rande berührt. Die p-Bereiche 4', 4'', 4''' und 4'''' werden so tief eingebracht, daß sie den Widerstandsbereich 2 bzw. das Substrat 1 berühren. Die p-Zone 4 wird in einem Arbeitsgang in den aus Substrat 1 und epitaktischer Schicht 3 bestehenden Halbleiterkörper eingebracht, und zwar beispielsweise durch Diffusion oder durch Ionenimplantation.

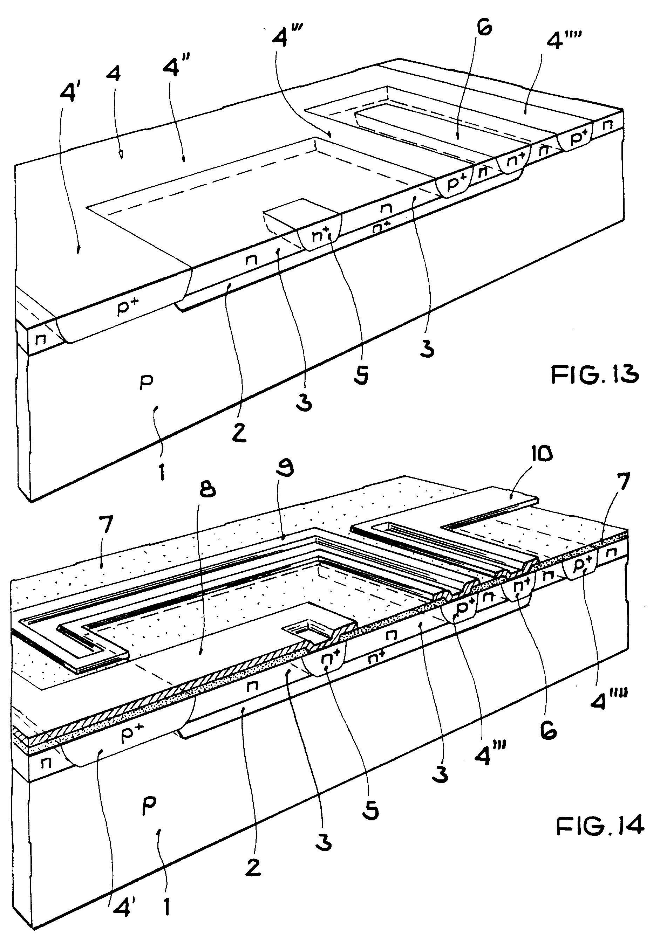

Der Anschluß des Widerstandsbereichs 2 erfolgt gemäß der Figur 13 durch die Anschlußzonen 5 und 6 vom n-Leitungstyp, die nach den p-Bereichen hergestellt werden, und zwar beispielsweise ebenfalls durch Diffusion oder durch Ionenimplantation. Die Anschlußzone 5 der Figur 13 dient zur Stromzufuhr für den Widerstandsbereich 2 und liegt in der Mitte des Widerstandsbereichs 2.

Die Figur 14 zeigt die fertige Schutzanordnung mit einer Isolierschicht 7 auf der Oberfläche der epitaktischen Schicht 3 sowie mit einer Leitbahn 8, die zur Anschlußzone 5 führt, mit einer Leitbahn 9, die die p-Bereiche 4', 4'' und 4''' miteinander verbindet und mit einer Leitbahn 10, die eine elektrische Verbindung zwischen der Anschlußzone 6 und der nachfolgenden, nicht dargestellten integrierten Schaltungsanordnung im selben Halbleiterkörper herstellt.

Die Figur 15 zeigt die Draufsicht auf die Schutzanordnung der Figur 14.

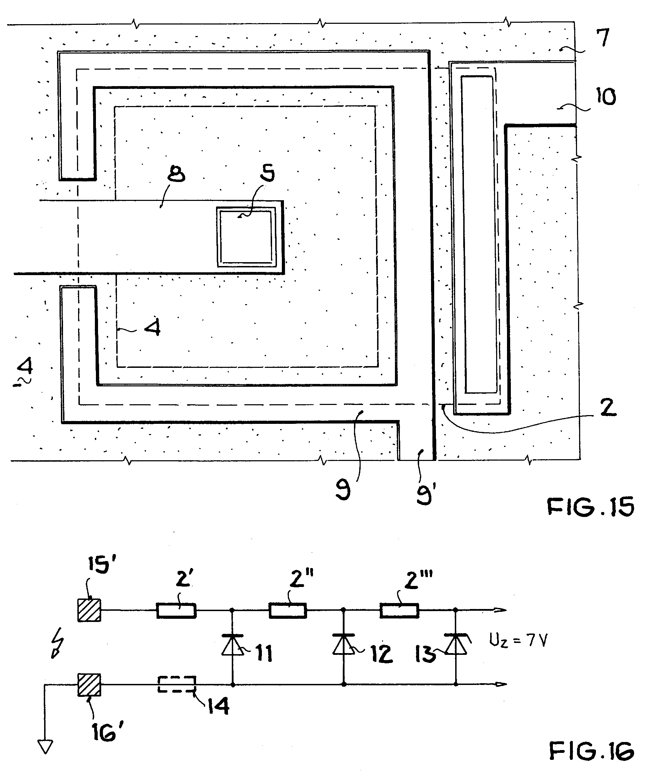

In der Figur 15 ist eine Leitbahn 9' angegebenen, die den Bezugspunkt der nachfolgenden, nicht dargestellten zu schützenden integrierten Schaltung mit dem Bezugspunkt (p-Bereiche 4, 4', 4'', 4''') der spannungsbegrenzenden Zenerdiode der erfindungsgemäßen Anordnung nach der Figur 13 verbindet.

Die Figur 16 zeigt das Ersatzschaltbild der Schutzanordnung der Figuren 14 und 15. Beim Ersatzschaltbild der Figur 16 ist der Widerstandsbereich 2 in die Widerstandsbereiche 2', 2'' und 2''' aufgeteilt, weil in der Ausführungsform der Erfindung nach Figur 14 und 15 zwischen dem Widerstandsbereich 2 und dem Substrat 1 eine großflächige Diode wirksam wird, die durch den pn-Übergang zwischen dem Widerstandsbereich 2 und dem Substrat 1 gebildet wird. Diese Diode wird in der Ersatzschaltung nach Figur 16 vereinfacht durch die Dioden 11 und 12 dargestellt. Die Zenerdiode ist mit der Bezugsziffer 13 bezeichnet. Der gestrichelt eingezeichnete Widerstand 14 stellt den Substratwiderstand dar. Die Anschlußpunkte der Schaltung sind mit den Bezugsziffern 15' und 16' bezeichnet.

Mit Hilfe der Ersatzschaltung nach Figur 16 kann die Funktionsweise der Schutzanordnung erklärt werden. Tritt an den Anschlußklemmen 15' und 16' eine der beschriebenen Störungen auf, so wird bei positiver Polarität der auftretenden Störspannung zwischen Anschluß 15' und 16' der Strom über die Widerstände 2', 2'', 2''', die Zenerdiode 13 als spannungsbegrenzendes Element, und den Substratwiderstand 14 fließen. Die Dioden 11 und 12 sind dann gesperrt. Weist die Störspannung zwischen 15' und 16' eine negative Polarität auf, werden die Dioden 11 und 12 leitend, d.h., daß der durch die Störung verursachte Strom über die Widerstandsbereiche 2', 2'' und 2''' zum Substrat über die dann in Flußrichtung wirksamen Dioden 11, 12 und 13 abfließt. Erfindungsgemäß werden die Widerstandsbereiche 2', 2'', 2''' und 14 so bemessen und ausgeführt, daß sie bei der zu erwartenden Spitzenbelastung, bis zu der die Schutzanordnung ihre Funktion zu erfüllen hat, den Hauptteil der Energie aufnimmt und die dabei erzeugte Wärme auf ein größeres Kristallvolumen abgibt. Um den durch den Stromfluß erzeugten Spannungsabfall an dem Substratwiderstand 14 nicht auf die nachfolgende zu schützende integrierte Schaltung wirksam werden zu lassen, ist vorzugsweise vorgesehen, daß als Bezugspunkt für die nachfolgende Schaltung der Verbindungspunkt von der Anode der Zenerdiode 13 und dem Substratbereich der Zenerdiode 13 gewählt wird.

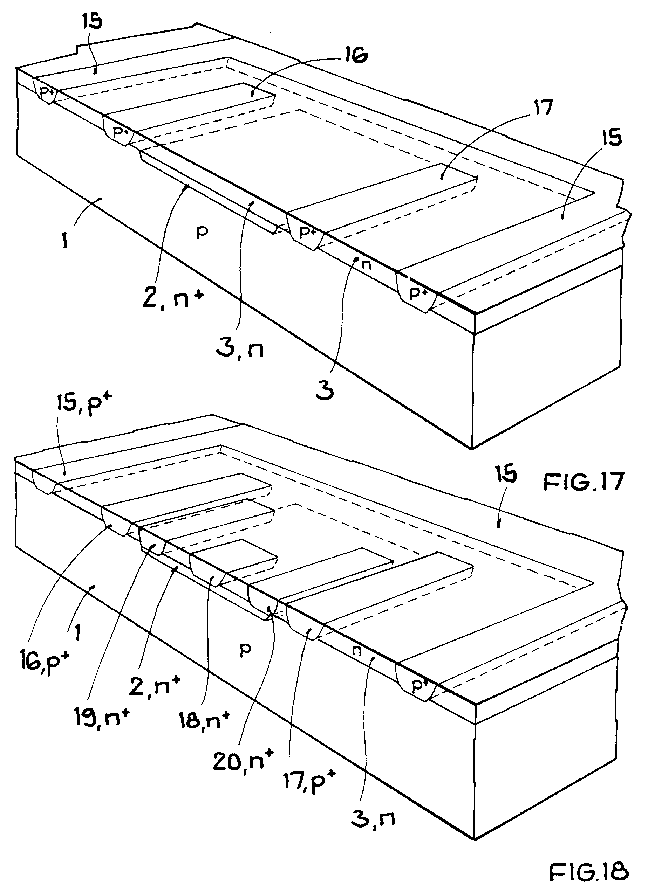

Im folgenden wird die Herstellung einer anderen Ausführungsform einer Schutzanordnung nach der Erfindung beschrieben. Nach der Figur 17 werden zur Herstellung dieser Schutzanordnung in einem Halbleiterkörper, der aus einem Substrat 1 vom p-Leitungstyp, einer buried layer 2 (Widerstandsbereich) vom n-Leitungstyp und einer epitaktischen Schicht 3 vom n-Leitungstyp besteht, die p-Zonen 15, 16 und 17 vom n-Leitungstyp eingebracht, und zwar bis zur Berührung mit dem Substrat 1. Die p-Zonen 15, 16 und 17 werden beispielsweise durch Diffusion oder durch Ionenimplantation hergestellt. Die p-Zone 15 dient als Separationszone, während die p-Zonen 16 und 17 Halbleiterzonen von Zenerdioden sind.

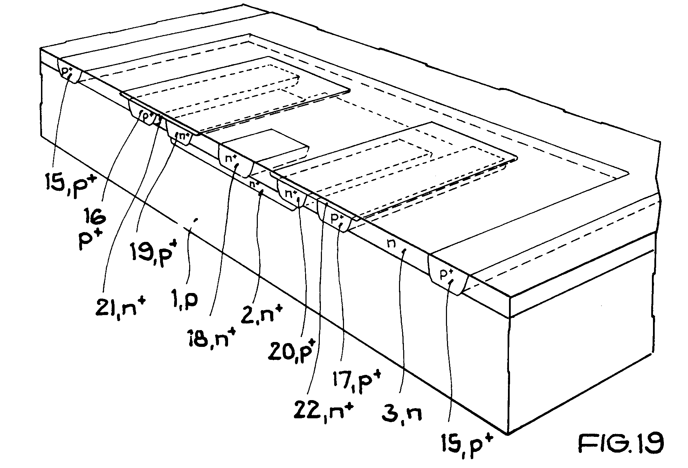

Nach der Herstellung der p-Zonen 15, 16 und 17 werden gemäß der Figur 18 die Anschlußzonen 18, 19 und 20 für den Widerstandsbereich 2 hergestellt. Die Anschlußzonen 18, 19 und 20 haben den n-Leitungstyp. Gemäß der Figur 19 werden anschließend die n-Zonen 21 und 22 hergestellt, deren Tiefe geringer ist als die Tiefe der zuvor in der epitaktischen Schicht 3 hergestellten Halbleiterzonen. Die Halbleiterzone 21 erstreckt sich von der Halbleiterzone 19 zur Halbleiterzone 16 und bedeckt diese beiden Halbleiterzonen. Die Halbleiterzone 22 erstreckt sich von der Halbleiterzone 17 zur Halbleiterzone 20 und überdeckt diese beiden Halbleiterzonen. Die Figur 19 weist zwei Zenerdioden auf, von denen die eine durch die Halbleiterzone 21 und die Halbleiterzone 16 gebildet wird, während die andere Zenerdiode durch die Halbleiterzonen 22 und 17 gebildet wird.

Die Überlappung der Halbleiterzone 16 ($p^+$-Zone) durch die Halbleiterzone 21 ($n^+$-Zone) und der Halbleiterzone 17 durch die Halbleiterzone 22 bewirkt, daß die Sperrschichten dieser Zonen an keiner Stelle die Oberfläche des Halbleiterkörpers 5 berühren, wodurch der p-n-Übergang vor Oberflächeneinflüßen geschützt ist.

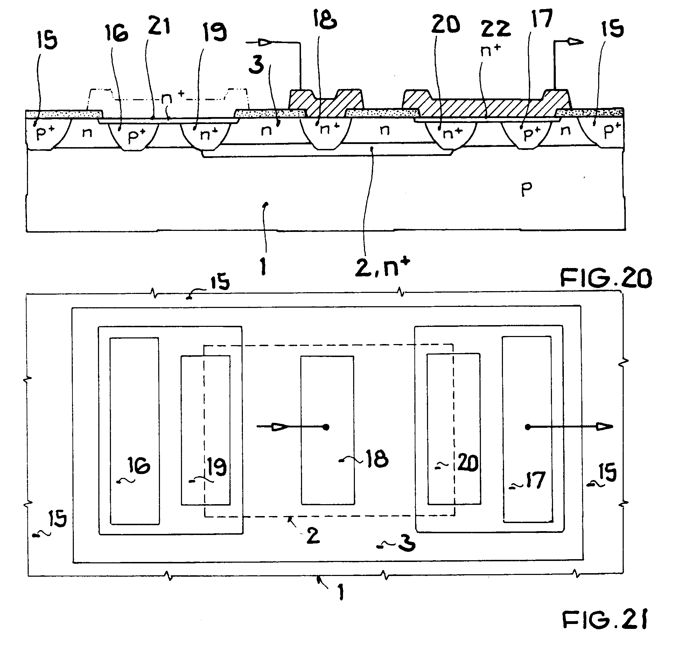

Die fertige Schutzanordnung zeigen die Figuren 20 und 21, und zwar die Figur 20 in der Schnittdarstellung und die Figur 21 in der Draufsicht.

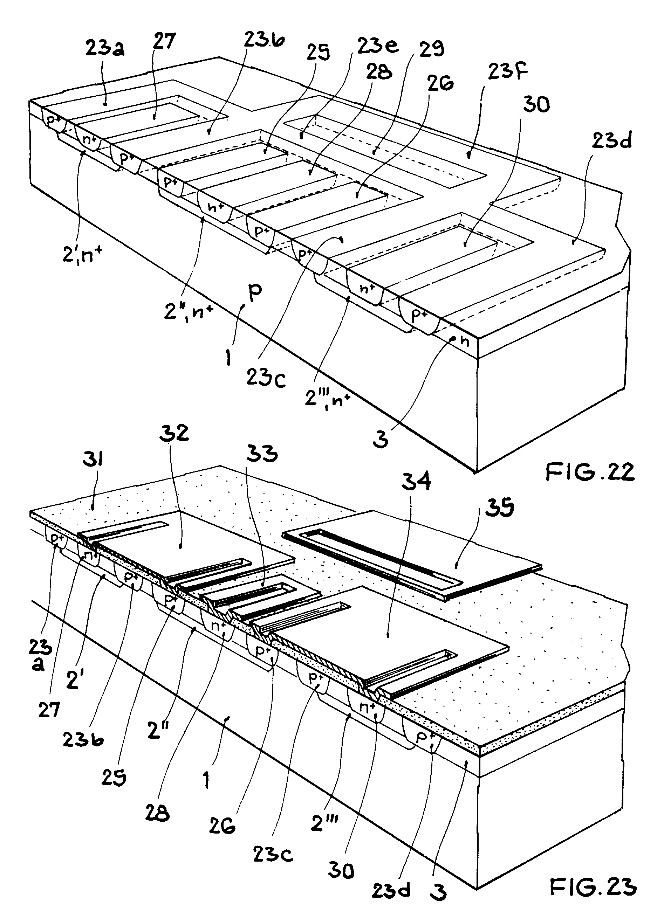

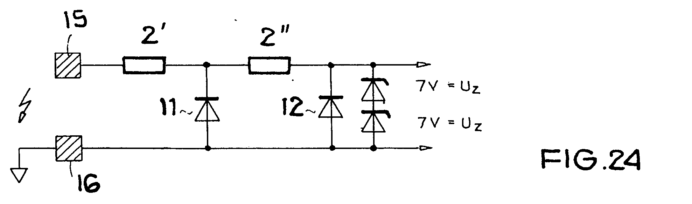

Während die Figuren 19, 20 und 21 eine Schutzanordnung zeigen, bei der zwei Zenerdioden zueinander parallel wirksam sind, zeigen die Figuren 22 und 23 eine Schutzanordnung, bei der je zwei Zenerdioden in Reihe geschaltet sind und diese Reihenschaltungen zueinander parallel wirksam sind. Nach der Figur 22 besteht der Halbleiterkörper dieser Schutzanordnung wieder aus einem Substrat 1 vom p-Leitungstyp und einer epitaktischen Schicht 3 vom n-Leitungstyp. Bei der Schutzanordnung der Figur 22 sind drei Widerstandsbereiche 2', 2'' und 2''' in Gestalt von buried layern vorgesehen. In die epitaktische Schicht 3 ist gemäß der Figur 22 eine Separationszone 23 vom p-Leitungstyp eingebracht, die aus den Bereichen 23a, 23b, 23c, 23e und 23f besteht. Der Separationsbereich 23a bildet mit dem Widerstandsbereich 2' eine Zenerdiode, der Separationsbereich 23b bildet mit dem Widerstandsbereich 2' eine Zenerdiode, der Separationsbereich 23c bildet mit dem Widerstandsbereich 2''' eine Zenerdiode und außerdem bildet der Separationsbereich 23d mit dem Widerstandsbereich 2''' eine Zenerdiode. Die Anschlußzone 27 vom n-Leitungstyp bildet einen Anschluß für den Widerstandsbereich 2', die Anschlußzonen 28 und 29 bilden Anschlüsse für den Widerstandsbereich 2'' und die Anschlußzone 30 vom n-Leitungstyp bildet einen Anschluß für den Widerstandsbereich 2'''. Die Figur 23 zeigt die fertige Schutzanordnung mit der Isolierschicht 31 auf der epitaktischen Schicht 3 und mit den Elektroden 32, 33, 34 und 35. Die Figur 24 zeigt das dazugehörige Ersatzschaltbild.

Eine Schutzanordnung nach den Figuren 22, 23 und 24 hat gegenüber der Schutzanordnung nach den Figuren 14, 20 und 21 den Vorteil, daß durch die in Reihe geschalteten Zenerdioden als spannungsbegrenzendes Element(e), die Betriebsspannung für die nachfolgende, zu schützende Schaltung entsprechend größer gewählt werden kann.

Ein Feldeffekttransistor in der Schutzanordnung hat die Aufgabe, den am Ausgang der Schutzanordnung im Störungsfall auftretenden Strom zu begrenzen, wodurch die Schutzfunktion erweitert wird. Dies erfolgt dadurch, daß beim Auftreten einer höheren (positiven) Störspannung an der Sourceelektrode der Kanalbereich des integrierten Feldeffekttransistors abgeschnürt wird. Die Verwendung eines Feldeffekttransistors am Ausgang einer erfindungsgemäßen Schutzanordnung ist für Ausführungen von Schutzanordnungen geeignet, die bereits beschrieben wurden.

Der Widerstand der Schutzanordnung, der bei Grenzbelastung den Hauptteil der Energie aufnehmen muß und der z.B. durch die Summe der Teilwiderstände 2', 2'' und 2''' in Figur 16 charakterisiert ist, ist vorzugsweise so zu bemessen, daß die Summe aus dem Spannungsabfall an diesem Widerstand und dem Wert der Zenerspannung im Falle der Grenzbelastung (maximal zu erwartender "Störstrom") den Wert der Durchbruchspannung, für die Strecke zwischen dem Anschluß-Pad 15 und dessen darunter befindlichen Bereich, z.B. Oxidschicht einschließlich n-Box, nicht erreicht.

Dies soll durch das nachfolgenden Beispiel verdeutlicht werden.
Unter den folgenden Annahmen:
- maximal auftretender Störstrom = 20 A (Figur 6),
- Zenerspannung (13 in Figur 16) = 7 V,
- zulässige Spitzenspannung zwischen Anschluß-Pad und n-Box = 150 V,
errechnet sich der maximal zulässige Widerstandswert, z.B. Summe der Teilbereiche 2', 2'', 2''' (Figur 16), zu

$$R_{max} = \frac{150\ V - 7\ V}{20\ A} = 7,15\ \Omega.$$

Daraus berechnet sich der Anteil der Spitzenleistung, die der Widerstandsbereich aufnimmt, zu

$P_R$ = (150 V - 7 V) x 20 A = 2,86 kW.

Der Anteil der von der Zenerdiode aufzunehmenden Spitzenleistung beträgt danach nur

$P_{ZD}$ = 7 V x 20 A = 140 W.

Aus dem Rechenbeispiel ist auch zu entnehmen, daß Zenerdioden mit niedrigerer Zenerspannung gegenüber solchen mit höherer Zenerspannung einen kleineren Anteil der Spitzenenergie aufnehmen. Wird die Verwendung des Widerstandes im Substratbereich, wie in der Ersatzschaltung nach Figur 16 mit dem Bezugszeichen 14 dargestellt, vorgesehen, so vermindert sich entsprechend die in den übrigen Bereichen auftretende, in Wärme umzusetzende Energie im Störungsfalle. Je kleiner der Anteil der im spannungsbegrenzenden Element (Zenerdiode) in Wärme umzusetzenden Energie ist, desto kleiner kann die Fläche dieses Elements ausgeführt sein. Das bedeutet, daß im Falle der Verwendung einer Zenerdiode als spannungsbegrenzendes Element bei Reduzierung deren Fläche, auch deren Sperrschichtkapazität, die, außer von den Dotierungsverhältnissen, von der Sperrschichtfläche abhängt, vermindert wird. Dies hat Bedeutung, wenn diese Sperrschichtkapazität negativen Einfluß auf die Funktion der integrierten Schaltung nimmt und mit Verminderung der Sperrschichtfläche dieser negative Einfluß vermieden oder vermindert werden kann.

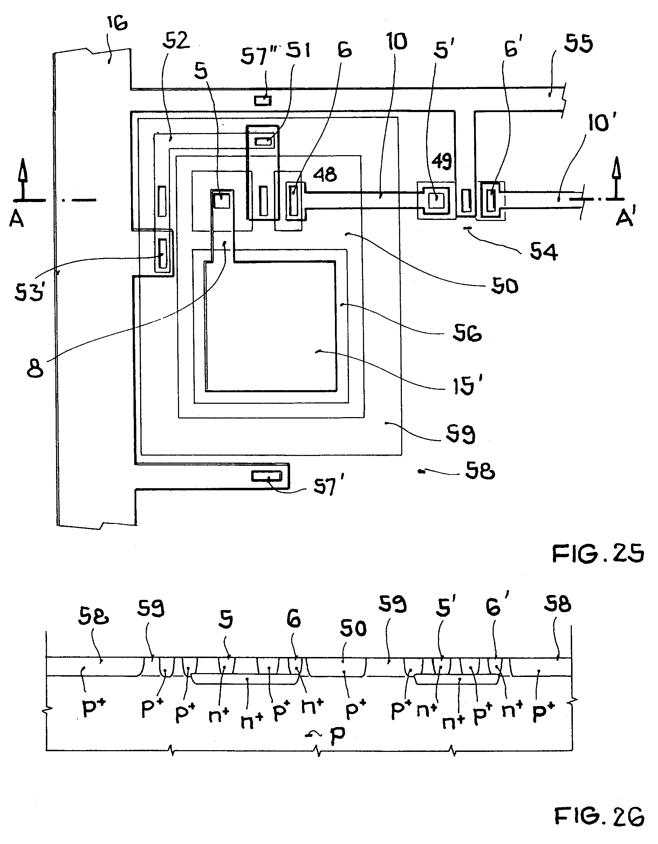

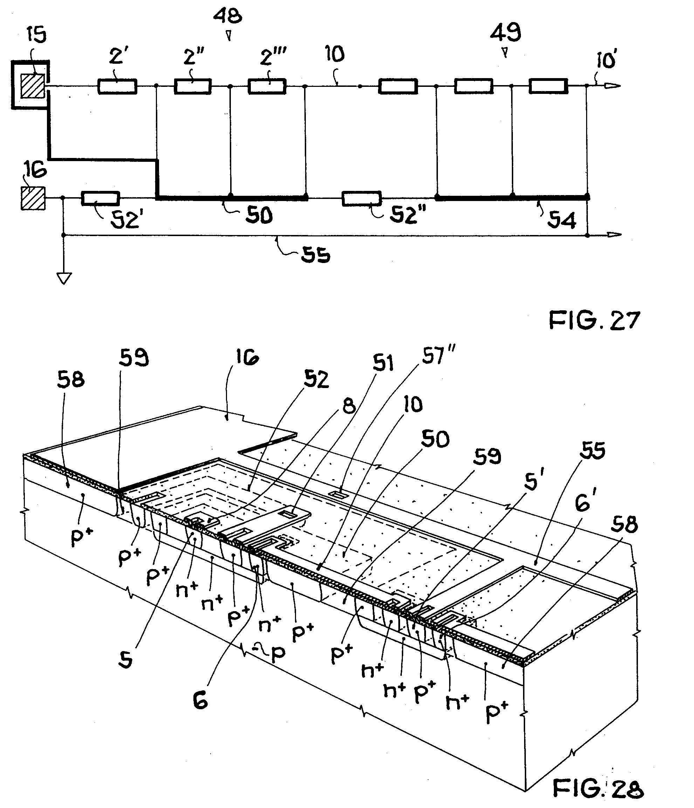

Die Figur 25 zeigt eine Weiterbildung der Erfindung, bei der neben einer ersten Schutzanordnung 48 eine zweite Schutzanordnung 49 vorgesehen ist. Die Schutzanordnungen 48 und 49 in der Anordnung nach der Figur 27 sind beispielsweise Ausführungen, wie sie an Hand der Figuren 10, 11, 12, 13, 14, 15 und 16 beschrieben wurden. Der Eingang 5 der ersten Schutzanordnung 48 ist über die Leitbahn 8 mit dem Anschluß-Pad 15' der integrierten Schaltung verbunden. Der Ausgangsanschluß 6 der ersten Schutzanordnung 48 ist über die Leitbahn 10 mit dem Eingang 5' der zweiten Schutzanordnung 49, und dessen Ausgang 6' über die Leitbahn 10' mit der (nicht dargestellten) zu schützenden Schaltungsanordnung verbunden. Die Leitbahn 51 verbindet den Substratbereich 50 der ersten Schutzanordnung 48 mit der Widerstandszone 52 vom p-Leitungstyp, während die Kontaktanschlußzone 53' mit dem Bezugspunkt 16' (Masse) der integrierten Schaltung verbunden ist. Der Substratbereich 54 der zweiten Schutzanordnung 49 ist über die Leitbahn 55 mit dem Bezugspunkt 16' der integrierten Schaltung und gleichzeitig mit dem Bezugspunkt der (nicht dargestellten) zu schützenden Schaltungsanordnung verbunden. In den Substratbereich ist auch die n-Zone 56, die dem Anschlußpad 15' zugeordnet ist, einbezogen. Der Substratbereich 50, in den die erste Schutzanordnung 48 eingebettet ist, ist vom Substratbereich 58, in den die zweite Schutzanordnung 49 eingebettet ist, durch eine n-Zone 59 "entkoppelt".

Die Figur 26 zeigt die Schnittdarstellung der einzelnen Halbleiterzonen, bezogen auf den Schnitt A-A' der Anordnung nach Figur 25 und die Figur 28 zeigt eine perspektivische Darstellung.

In der Figur 27 ist die Ersatzschaltung der Anordnung nach der Figur 25 mit den Elementen der ersten Schutzanordnung 48 und der zweiten Schutzanordnung 49 dargestellt. Die Wirkungsweise der Schutzanordnungen wurden bereits beschrieben. Die Ersatzschaltung nach Figur 27 soll im wesentlichen die "Entkopplung" der Substratbereiche der beiden Schutzanordnungen 48 und 49 aufzeigen. Wie in der Figur 27 dargestellt, ist der Substratbereich 50 durch die Widerstände 52' und 52'' mit dem Bezugspunkt 16' der integrierten Schaltung verbunden, wobei durch eine Anordnung der Halbleiterzonen nach Figur 25 der Widerstand 52' im allgemeinen kleiner ist als der Widerstand 52''. Dadurch ist der Substratbereich 54 der zweiten Schutzanordnung 49 über die Leitung 55 dem Bezugspunkt 16' zuordenbar, wodurch der wirksame Widerstand zwischen der Substratzone 50 und dem Bezugspunkt 16' getrennt bemessen werden kann. Beispielsweise kann der wirksame Widerstand zwischen der Substratzone 50 und dem Bezugpunkt 16' durch die Ausführung der Widerstandszone 52 in der Figur 25 bestimmt werden.

Der Vorteil der Anordnung nach der figur 25 besteht darin, daß sowohl für die zu schützende Schaltungsanordnung, die der zweiten Schutzanordnung (49) nachgeschaltet ist, als auch für die übrigen Teile der integrierten Schaltung, wegen der "Entkopplung" der Substratbereiche eine größere Schutzwirkung erzielt wird. Ein weiterer Vorteil der Anordnung nach Figur 25 besteht in der Möglichkeit, durch entsprechende Bemessung des Substratwiderstandes (52', 52'') den Anteil der von diesem Substratwiderstand aufgenommenen Entladungsenergie (Störung) so groß zu wählen, daß die Schutzanordnung 48 und 49 hinsichtlich Kristallflächenbedarf entsprechend kleiner gewählt werden können.

In den Ausführungsbeispielen hat zwar das Substrat der integrierten Schaltungsanordnung den p-Leitungstyp, doch gilt die Erfindung natürlich auch für integrierte Schaltkreise mit einem Substrat vom n-Leitungstyp und entsprechend angepaßtem Leitungstyp der anderen Halbleiterzonen.

Der nach der Erfindung vorgesehene Widerstand, der zum Schutz vor energiereichen elektrischen Störungen vorgesehen ist, wird, gemäß der Figur 16 vorzugsweise mit demjenigen Anschluß (Pin 15', 16') der integrierten Schaltungsanordnung elektrisch verbunden, auf den die unerwünschte elektrische Störung einwirkt.

## Patentansprüche

1. Integrierte Halbleiteranordnung, die zum Schutz einer integrierten Schaltungsanordnung vor energiereichen elektrischen Störungen zwischen einem Anschluß-Pad (15) und der zu schützenden, integrierten Schaltung angeordnet ist, mit wenigstens einem in einem Halbleitersubstrat (1) eines zweiten Leitungstyps als vergrabene Schicht ausgebildeten Widerstandsbereich (2) eines ersten Leitungstyps, der mit dem Substrat (1) eine Diode bildet, mit einer epitaktischen Halbleiterschicht (3) vom ersten Leitungstyp, die sich auf dem Halbleitersubstrat (1) und dem Widerstandsbereich (2) befindet, wobei der Anschluß der integrierten Schaltung an das Anschluß-Pad (15) über den als vergrabene Schicht ausgebildeten Widerstandsbereich (2), der eine höhere Dotierung als die epitaktische Halbleiterschicht (3) aufweist, geführt wird, dadurch gekennzeichnet, daß in der epitaktischen Schicht (3) vom ersten Leitungstyp Halbleiterbereiche (4', 4'', 4''') des zweiten Leitungstyps vorgesehen sind, die mit dem Substrat (1) und dem Widerstandsbereich (2) direkt verbunden sind und mit dem Widerstandsbereich Zenerdioden bilden, die bei Erreichen der Durchbruchspannung die Störung in das Substrat (1) ableiten.

2. Integrierte Halbleiteranordnung, die zum Schutz einer integrierten Schaltungsanordnung vor energiereichen elektrischen Störungen zwischen einem Anschluß-Pad (15) und der zu schützenden, integrierten Schaltung angeordnet ist, mit wenigstens einem in einem Halbleitersubstrat (1) eines zweiten Leitungstyps als vergrabene Schicht ausgebildeten Widerstandsbereich (2) eines ersten Leitungstyps, der mit dem Substrat (1) eine Diode bildet, mit einer epitaktischen Halbleiterschicht (3) vom ersten Leitungstyp, die sich auf dem Halbleitersubstrat (1) und dem Widerstandsbereich (2) befindet, wobei der Anschluß der integrierten Schaltung an das Anschluß-Pad (15) über den als vergrabene Schicht ausgebildeten Widerstandsbereich (2), der eine höhere Dotierung als die epitaktische Halbleiterschicht (3) aufweist, geführt wird, dadurch gekennzeichnet, daß in der epitaktischen Schicht (3) vom ersten Leitungstyp Halbleiterbereiche (16, 17) des zweiten Leitungstyps vorgesehen sind, die mit dem Substrat (1) direkt und dem Widerstandsbereich (2) über Anschlußzonen (21, 22) vom zweiten Leitungstyp verbunden sind und mit den Anschlußzonen (21, 22) Zenerdioden bilden, die bei Erreichen der Durchbruchspannung die Störung in das Substrat (1) ableiten.

3. Integrierte Halbleiteranordnung nach einem der Ansprüche 1 bis 2, dadurch gekennzeichnet, daß der Widerstandsbereich (2) Bereiche unterschiedlichen Widerstandes aufweist.

4. Integrierte Halbleiteranordnung nach einem der Ansprüche 1 bis 3, dadurch gekennzeichnet, daß für den elektrischen Anschluß des Widerstandsbereichs (2) mindestens eine Anschlußzone (5, 6, 18, 28, 35) vom Leitungstyp des Widerstandsbereichs (2) vorgesehen ist, die sich von der Halbleiteroberfläche bis zum Widerstandsbereich (2) erstreckt.

5. Integrierte Halbleiteranordnung nach einem der Ansprüche 1 bis 4, dadurch gekennzeichnet, daß der Widerstandsbereich (2) oder die Widerstandsbereiche (2', 2'', 2''') einen rechteckförmigen oder einen kreisförmigen Querschnitt aufweist, bzw. aufweisen.

6. Integrierte Halbleiteranordnung nach einem der Ansprüche 4 bis 5, dadurch gekennzeichnet, daß die Stromzuführung für den Widerstandsbereich (2) durch die Anschlußzone (5) im Zentrum des Widerstandsbereichs (2) erfolgt.

7. Integrierte Halbleiteranordnung nach einem der Ansprüche 1 bis 6, dadurch gekennzeichnet, daß sich die Halbleiterbereiche (4', 4'', 4''') von der Halbleiteroberfläche aus bis zu dem unter diesen Halbleiter-

EP 0 293 575 B1

bereichen (4', 4'', 4''') befindlichen Widerstandsbereich (2) erstrecken.

8. Integrierte Halbleiteranordnung nach einem der Ansprüche 1 bis 7, dadurch gekennzeichnet, daß die Halbleiterbereiche (4', 4'', 4'''), die mit dem Widerstandsbereich (2) die Zenerdiode bilden, als ringförmige Halbleiterzone ausgebildet sind.

9. Integrierte Halbleiteranordnung nach Anspruch 8, dadurch gekennzeichnet, daß eine erste Anschlußzone (5) für den Widerstandsbereich (2) innerhalb des ringförmigen Halbleiterbereichs (4', 4'', 4''') und eine zweite Anschlußzone (6) für den Widerstandsbereich (2) außerhalb des ringförmigen Halbleiterbereichs (4', 4'', 4''') vorgesehen ist und daß die zweite Anschlußzone für den Widerstandsbereich (2) den Ausgang der Schutzanordnung bildet.

10. Integrierte Halbleiteranordnung nach einem der Ansprüche 1 bis 9, dadurch gekennzeichnet, daß eine Separationszone (23) vorgesehen ist, die durch einen Teil der Halbleiterbereiche (4', 4'', 4''') sowie durch eine gesonderte, jedoch mit den Halbleiterbereichen (4', 4'', 4''') zusammenhängende Halbleiterzone vom zweiten Leitungstyp gebildet ist.

11. Integrierte Halbleiteranordnung nach einem der Ansprüche 1 bis 10, dadurch gekennzeichnet, daß zwei Zenerdioden, die jeweils durch wenigstens einen Halbleiterbereich (23a - 23d) vom zweiten Leitungstyp sowie je durch einen Widerstandsbereich (2', 2'', 2''') gebildet sind, miteinander in Reihe geschaltet sind.

12. Integrierte Halbleiteranordnung nach Anspruch 11, dadurch gekennzeichnet, daß die Reihenschaltung der beiden Zenerdioden über eine Leitbahn erfolgt, die einerseits mit dem Halbleiterbereich (23a - 23d) vom zweiten Leitungstyp der einen Zenerdiode sowie andererseits mit einer Anschlußzone (27, 28, 30) verbunden ist, die einen Widerstandsbereich (2', 2'', 2''') kontaktiert, der zusammen mit einem Halbleiterbereich (23a - 23d) vom zweiten Leitungstyp den pn-Übergang der anderen Zenerdiode bildet.

13. Integrierte Halbleiteranordnung nach einem der Ansprüche 1 bis 12, dadurch gekennzeichnet, daß ein strombegrenzendes Element am Ausgang der Schutzanordnung vorgesehen ist.

14. Integrierte Halbleiteranordnung nach Anspruch 13, dadurch gekennzeichnet, daß als strombegrenzendes Element ein Feldeffekttransistor vorgesehen ist.

15. Integrierte Halbleiteranordnung nach einem der Ansprüche 1 bis 14, dadurch gekennzeichnet, daß eine zweite Schutzanordnung vorgesehen ist, die der ersten Schutzanordnung nachgeschaltet ist.

**Claims**

1. An integrated semiconductor arrangement which, for the protection of an integrated circuit arrangement from high-energy electrical disturbances, is arranged between a terminal pad (15) and the integrated circuit to be protected, with at least one resistance zone (2) of a first conductivity type which is formed as buried layer in a semiconductor substrate (1) of a second conductivity type and which together with the substrate (1) forms a diode, with an epitaxial semiconductor layer (3) of the first conductivity type which is arranged on the semiconductor substrate (1) and the resistance zone (2), wherein the terminal of the integrated circuit leads to the terminal pad (15) via the resistance zone (2) which has the form of a buried layer and which possesses a higher level of doping than the epitaxial semiconductor layer (3), characterised in that in the epitaxial layer (3) of the first conductivity type there are provided semiconductor zones (4', 4'', 4''') of the second conductivity type which are directly connected to the substrate (1) and to the resistance zone (2) and together with the resistance zone form zener diodes which divert the disturbance into the substrate (1) when the breakdown voltage is reached.

2. An integrated semiconductor arrangement which, for the protection of an integrated circuit arrangement from high-energy electrical disturbances, is arranged between a terminal pad (15) and the integrated circuit to be protected, with at least one resistance zone (2) of a first conductivity type which is formed as buried layer in a semiconductor substrate (1) of a second conductivity type and which together with the substrate (1) forms a diode, with an epitaxial semiconductor layer (3) of the first conductivity type which is arranged on the semiconductor substrate (1) and the resistance zone (2), wherein the terminal

9

of the integrated circuit leads to the terminal pad (15) via the resistance zone (2) which has the form of a buried layer and which possesses a higher level of doping than the epitaxial semiconductor layer (3), characterised in that in the epitaxial layer (3) of the first conductivity type there are provided semiconductor zones (16, 17) of the second conductivity type which are connected to the substrate (1) directly and to the resistance zone (2) via terminal zones (21, 22) of the second conductivity type and together with the terminal zones (21, 22) form zener diodes which divert the disturbance into the substrate when the breakdown voltage is reached.

3. An integrated semiconductor arrangement as claimed in one of Claims 1 to 2, characterised in that the resistance zone (2) comprises zones of different resistance.

4. An integrated semiconductor arrangement as claimed in one of Claims 1 to 3, characterised in that for the electrical connection of the resistance zone (2) at least one terminal zone (5, 6, 18, 28, 35) of the conductivity type of the resistance zone (2) is provided, which terminal zone extends from the semiconductor surface to the resistance zone (2).

5. An integrated semiconductor arrangement as claimed in one of Claims 1 to 4, characterised in that the resistance zone (2) or the resistance zones (2', 2'', 2''') possess(es) a rectangular or circular cross-section.

6. An integrated semiconductor arrangement as claimed in one of Claims 4 to 5, characterised in that the current for the resistance zone (2) is supplied through the terminal zone (5) in the centre of the resistance zone (2).

7. An integrated semiconductor arrangement as claimed in one of Claims 1 to 6, characterised in that the semiconductor zones (4', 4'', 4''') extend from the semiconductor surface to the resistance zone (2) located beneath these semiconductor zones (4', 4'', 4''').

8. An integrated semiconductor arrangement as claimed in one of Claims 1 to 7, characterised in that the semiconductor zones (4', 4'', 4''') which together with the resistance zone (2) form the zener diode have the form of an annular semiconductor zone.

9. An integrated semiconductor arrangement as claimed in Claim 8, characterised in that a first terminal zone (5) for the resistance zone (2) is provided within the annular semiconductor zone (4', 4'', 4''') and a second terminal zone (6) for the resistance zone (2) is provided outside of the annular semiconductor zone (4', 4'', 4''') and that the second terminal zone for the resistance zone (2) forms the output of the protective arrangement.

10. An integrated semiconductor arrangement as claimed in one of Claims 1 to 9, characterised in that a separation zone (23) is provided which is formed by a part of the semiconductor zones (4', 4'', 4''') and by a separate semiconductor zone of the second conductivity type which however is linked to the semiconductor zones (4', 4'', 4''').

11. An integrated semiconductor arrangement as claimed in one of Claims 1 to 10, characterised in that two zener diodes which are formed in each case by at least one semiconductor zone (23a - 23d) of the second conductivity type and by a respective resistance zone (2', 2'', 2''') are connected in series with one another.

12. An integrated semiconductor arrangement as claimed in Claim 11, characterised in that the series connection of the two zener diodes takes place via a conductor path which is connected on the one hand to the semiconductor zone (23a - 23d) of the second conductivity type of the first zener diode and on the other hand to a terminal zone (27, 28, 30) which contacts a resistance zone (2', 2'', 2''') which, together with a semiconductor zone (23a - 23d) of the second conductivity type, forms the pn-junction of the other zener diode.

13. An integrated semiconductor arrangement as claimed in one of Claims 1 to 12, characterised in that a current-limiting element is provided at the output of the protective arrangement.

**EP 0 293 575 B1**

**14.** An integrated semiconductor arrangement as claimed in Claim 13, characterised in that a field effect transistor is provided as current-limiting element.

**15.** An integrated semiconductor arrangement as claimed in one of Claims 1 to 14, characterised in that a second protective arrangement is provided which is connected following the first protective arrangement.

**Revendications**

**1.** Dispositif semi-conducteur intégré qui est agencé, en vue de la protection d'un circuit intégré contre des perturbations électriques riches en énergie, entre un plot de connexion (15) et le circuit intégré à protéger, dispositif qui comprend au moins une région résistive (2) d'un premier type de conductivité, réalisée comme une couche enterrée dans un substrat semiconducteur (1) d'un second type de conductivité et formant avec ce substrat (1) une diode, et qui comprend une couche de semi-conducteur épitactique (3) du premier type de conductivité, qui se trouve sur le substrat semi-conducteur (1) et la région résistive (2), le raccordement du circuit intégré au plot de connexion (15) passant par la région résistive (2), réalisée comme une couche enterrée et présentant un plus fort dopage que la couche de semi-conducteur épitactique (3), caractérisé par la prévision, dans la couche épitactique (3) du premier type de conductivité, de régions de semi-conducteur (4', 4'', 4''') du second type de conductivité, qui sont reliées directement au substrat (1) et à la région résistive (2) et forment avec la région résistive des diodes Zener qui, lorsque la tension d'avalanche est atteinte, dissipent la perturbation dans le substrat (1).

**2.** Dispositif semi-conducteur intégré qui est agencé, en vue de la protection d'un circuit intégré contre des perturbations électriques riches en énergie, entre un plot de connexion (15) et le circuit intégré à protéger, dispositif qui comprend au moins une région résistive (2) d'un premier type de conductivité, réalisée comme une couche enterrée dans un substrat semiconducteur (1) d'un second type de conductivité et formant avec ce substrat (1) une diode, et qui comprend une couche de semi-conducteur épitactique (3) du premier type de conductivité, qui se trouve sur le substrat semi-conducteur (1) et la région résistive (2), le raccordement du circuit intégré au plot de connexion (15) passant par la région résistive (2), réalisée comme une couche enterrée et présentant un plus fort dopage que la couche de semi-conducteur épitactique (3), caractérisé par la prévision, dans la couche épitactique (3) du premier type de conductivité, de régions de semi-conducteur (16, 17) du second type de conductivité, qui sont reliées directement au substrat (1) et à travers des zones de connexion (21, 22) du second type de conductivité à la région résistive (2) et qui forment avec les zones de connexion (21, 22) des diodes Zener qui, lorsque la tension d'avalanche est atteinte, dissipent la perturbation dans le substrat (1).

**3.** Dispositif semi-conducteur intégré selon la revendication 1 ou 2, caractérisé en ce que la région résistive (2) comporte des régions ayant des résistances différentes.

**4.** Dispositif semi-conducteur intégré selon une des revendications 1 à 3, caractérisé en ce que, pour le raccordement électrique de la région résistive (2), on a prévu au moins une zone de connexion (5, 6, 18, 28, 35) ayant le type de conductivité de la région résistive (2) et qui s'étend de la surface du semi-conducteur jusqu'à la région résistive (2).

**5.** Dispositif semi-conducteur intégré selon une des revendications 1 à 4, caractérisé en ce que la région résistive (2) ou les régions résistives (2', 2'', 2''') présente(nt) une section droite rectangulaire ou circulaire.

**6.** Dispositif semi-conducteur intégré selon une des revendications 1 à 5, caractérisé en ce que l'amenée du courant pour la région résistive (2) s'effectue à travers la zone de connexion (5) au centre de la région résistive (2).

**7.** Dispositif semi-conducteur intégré selon une des revendications 1 à 6, caractérisé en ce que les régions de semi-conducteur (4', 4'', 4''') s'étendent jusqu'à la région résistive (2) se trouvant sous ces régions de semi-conducteur (4', 4'', 4''').

11

**8.** Dispositif semi-conducteur intégré selon une des revendications 1 à 7, caractérisé en ce que les régions de semi-conducteur (4', 4'', 4''') formant une diode Zener avec la région résistive (2), sont réalisées comme une zone de semi-conducteur annulaire.

**9.** Dispositif semi-conducteur intégré selon la revendication 8, caractérisé en ce qu'une première zone de connexion (5) pour la région résistive (2) est prévue à l'intérieur de la région de semi-conducteur annulaire (4', 4'', 4''') et une seconde zone de connexion (6) pour la région résistive (2) est prévue à l'extérieur de cette région de semi-conducteur annulaire (4', 4'', 4'''), et que la seconde zone de connexion pour la région résistive (2) forme la sortie du dispositif de protection.

**10.** Dispositif semi-conducteur intégré selon une des revendications 1 à 9, caractérisé en ce qu'une zone de séparation (23) est prévue, qui est formée par une partie des régions de semi-conducteur (4', 4'', 4''') ainsi que par une zone de semi-conducteur séparée, mais d'un seul tenant avec les régions de semi-conducteur (4', 4'', 4'''), qui possède le second type de conductivité.

**11.** Dispositif semi-conducteur intégré selon une des revendications 1 à 10, caractérisé en ce que deux diodes Zener, constituées chacune par au moins une région de semi-conducteur (23a - 23d) du second type de conductivité, ainsi que par une région résistive (2', 2'', 2'''), sont montées en série entre elles.

**12.** Dispositif semi-conducteur intégré selon la revendication 11, caractérisé en ce que le montage en série des deux diodes Zener est réalisé par une piste conductive qui est reliée d'une part à la région de semi-conducteur (23a - 23d) du second type de conductivité d'une diode Zener et, d'autre part, à une zone de connexion (27, 28, 30) en contact avec une région résistive (2', 2'', 2''') formant, ensemble avec une région de semi-conducteur (23a - 23d) du second type de conductivité, la jonction pn de l'autre diode Zener.

**13.** Dispositif semi-conducteur intégré selon une des revendications 1 à 12, caractérisé en ce qu'un élément limiteur de courant est prévu à la sortie du dispositif de protection.

**14.** Dispositif semi-conducteur intégré selon la revendication 13, caractérisé en ce que l'élément limiteur de courant est un transistor à effet de champ.

**15.** Dispositif semi-conducteur intégré selon une des revendications 1 à 14, caractérisé en ce qu'un deuxième dispositif de protection est prévu, qui est monté à la suite du premier dispositif de protection.

FIG.1

FIG.2

FIG.3

FIG.4

LASTNACHBILDUNG

FIG.5

FIG.6

14

FIG. 7

FIG.8

FIG.9

FIG.10

EP 0 293 575 B1

FIG.11

FIG.12

FIG.13

FIG.14

FIG.15

$U_z = 7V$

FIG.16

15

16

17

15

1

P

2, n⁺

3, n

3

FIG.17

15, p⁺

15

16, p⁺

1

P

n

p⁺

19, n⁺

2, n⁺

18, n⁺

20, n⁺

17, p⁺

3, n

FIG.18

15,$p^+$

16 $p^+$

19,$p^+$

21,$n^+$   1,$p$

18,$n^+$   2,$n^+$

20,$p^+$

17,$p^+$

22,$n^+$   3,$n$

15,$p^+$

FIG.19

FIG.20

FIG.21

FIG.22

FIG.23

FIG.24

FIG. 25

FIG. 26

FIG. 27

FIG. 28